# EUROPEAN PATENT APPLICATION

(11) **EP 1 591 555 A1**
(43) Date of publication of application: **02.11.2005**
(21) Application number: 03753995.4
(22) Date of filing: 02.10.2003
(51) Int. Cl.: C23C 14/34, C22C 1/04, C22C 28/00

(54) **Ge-Cr ALLOY SPUTTERING TARGET AND PROCESS FOR PRODUCING THE SAME**

(30) Priority: 27.01.2003 JP 2003017025
(71) Applicant: Nikko Materials Company, Limited, Tokyo 105-8407 (JP)
(72) Inventor: TAKAMI, Hideo c/o Isohara Factory of Nikko, Kitaibaraki-shi, Ibaraki 319-1535 (JP); AJIMA, Hirohisa c/o Isohara Factory of Nikko, Kitaibaraki-shi, Ibaraki 319-1535 (JP)
(74) Representative: Hoarton, Lloyd Douglas Charles
(86) International application number: PCT/JP2003/012660
(87) International publication number: WO 2004/067798

(57) **Abstract**

A Ge-Cr alloy sputtering target containing 5 to 50at% of Cr and having a relative density of 95% or more, and a manufacturing method of such a Ge-Cr alloy sputtering target wherein Cr powder having a minus sieve of 75µm or less, and Ge powder having a minus sieve of 250µm or less and having a BET specific surface area of 0.4m²/g or less are dispersively mixed in an even manner, and sintered thereafter.

Thereby provided is a Ge-Cr alloy sputtering target capable of suppressing variation of the deposition speed and film composition, as well as improving the production yield, of the GeCrN layer deposited with reactive sputtering as the intermediate layer between the recording layer and protective layer of a phase-change optical disk, and the manufacturing method of such a target.

## Description

### TECHNICAL FIELD

The present invention relates to a Ge-Cr alloy sputtering target capable of suppressing the deposition speed variation and the accompanying composition deviation, and obtaining stable sputtering characteristics upon forming a GeCrN thin film with reactive sputtering employing the Ge-Cr alloy sputtering target, and the manufacturing method thereof.

### BACKGROUND ART

In recent years, high density recordable optical disc technology capable of recording/reproduction without requiring a magnetic head has been developed, and is rapidly attracting attention. This optical disc can be classified into the three categories of read-only, write-once and rewritable. Particularly, the phase change method employed in the write-once or rewritable type discs is attracting attention.

This phase change optical disc performs the recording/reproduction of information by heating and increasing the temperature of a recording thin film on a substrate by irradiating a laser beam thereto, and generating a crystallographic phase change (amorphous ⇔ crystal) in the structure of such recording thin film. More specifically, the reproduction of information is performed by detecting the change in the reflectivity caused by the change in the optical constant of the phase.

The aforementioned phase change is performed with the irradiation of a laser beam narrowed down to a diameter of approximately 1 to several µm. Here, for example, when a 1µm laser beam passes through at a linear velocity of 10m/s, light is irradiated to a certain point on the optical disc for 100ns, and it is necessary to perform the aforementioned phase change and detect the reflectivity within such time interval.

Moreover, in order to realize the foregoing crystallographic phase change, that is, the phase change between amorphous phase and crystal, not only will the phase change recording layer be subject to fusion and quenching more than once, the peripheral dielectric protective layer and aluminum alloy will also be repeatedly subject thereto.

In light of the above, a phase change optical disc has a four-layer structure wherein both sides of the recording thin film layer of a Ge-Sb-Te are sandwiched with protective layers of a zinc sulfide - silicon oxide (ZnS-SiO₂) high-melting point dielectric, and an aluminum alloy reflective layer is additionally provided thereto.

In the above-mentioned structure, demanded of an optical function capable of increasing the absorption in the amorphous portion and crystal portion and giving a large reflectivity difference, also of a function for giving the recording film the resistivity to moisture and preventing the deformation caused by the heat of the recording thin film as well as a function for controlling the thermal conditions upon recording (c.f. "*Kogaku*" magazine, volume 26, no. 1, pages 9 to 15).

As described above, the protective layer of a high-melting point dielectric must be durable against repeated thermal stress caused by the heating and cooling, must not allow such thermal effect to influence the reflective film or other areas, and it is also required to be thin, of low reflectivity, and of strong resistivity against deterioration. From this perspective, the dielectric protective layer plays an important role.

Generally speaking, although a phase change optical disk such as a DVD-RAM guarantees the number of rewritings 10⁵ to 10⁶ times, there are problems of the rewriting characteristics deteriorating as a result of S or the like diffusing from the zinc sulfide - silicon oxide (ZnS-SiO₂) layer used for protecting the foregoing recording layer.

As a method of overcoming this problem, an intermediate layer is being provided between the recording layer and protective layer, and, in particular, GeCrN materials are being proposed as the material for such intermediate layer.

Upon forming a GeCrN intermediate layer, a Ge-Cr alloy target is generally used, and reactive sputtering is performed in a nitrogen gas atmosphere.

Nevertheless, with a conventional target, there was deposition speed variation, and there were problems in that such variation would trigger the deviation of the film composition, which would result in defective products and deterioration of the production yield.

As conventional technology, disclosed is technology which uses Ge-Cr materials and the like, and a compositional discontinuous face orthogonal to the thickness direction is set, and the space between the upper face, which is the face on the side in which sputtering is started, and the compositional discontinuous face is defined as a first region. Moreover, for forming a thin film containing a plurality of components in a desired ratio from immediately after the start of use, the content of each component in the 1 st region is set in such a manner that the lower is the sputtering rate of a component, the higher is its concentration as compared with the desired ratio of the formed thin film (c.f. Japanese Patent Laid-Open Publication No. 2000-178724).

Further, as a conventional Ge-Cr sputtering target, disclosed is a sputtering target in which, when the X-ray diffraction intensity is measured with the sputtering target, the ratio of a peak intensity of (220) plane against a peak intensity of (111) plane, (I ₂₂₀/I ₁₁₁), is 0.3 or more, and the spread of the peak-intensity ratio I ₂₂₀/I ₁₁₁ on the whole target-surface is within ±30% (cf., for example, Japanese Patent Laid-Open Publication No. 2002-38258).

Moreover, as a conventional Ge-Cr sputtering target, disclosed is a target in which the Ag content and the Au content in the high-purity Ge or Ge alloy are each 5ppm or below, and the variation of the Ag content and Au content in the whole target are each within 30% (cf., for example, Japanese Patent Laid-Open Publication No. 2002-69624).

### DISCLOSURE OF THE INVENTION

An object of the present invention is to provide a Ge-Cr alloy sputtering target capable of suppressing the variation of the deposition speed and film composition, as well as improving the production yield, of the GeCrN layer deposited by reactive sputtering as the intermediate layer between the recording layer and protective layer of a phase-change optical disk, and the manufacturing method of such a target.

In order to achieve the foregoing object, as a result of intense study, the present inventors discovered that the variation of the deposition speed and film composition can be suppressed and the production yield can be improved by optimizing the conditions of the target density, and the variation of the density and composition.

Based on the foregoing discovery, the present invention provides:
1. A Ge-Cr alloy sputtering target containing 5 to 50at% of Cr and having a relative density of 95% or more;
2. A Ge-Cr alloy sputtering target according to paragraph 1 above, wherein the relative density is 97% or more;
3. A Ge-Cr alloy sputtering target according to paragraph 1 or paragraph 2 above, wherein the density variation in the target is within ±1.5%;
4. A Ge-Cr alloy sputtering target according to any one of paragraphs 1 to 3 above, wherein the composition variation in the target is within ±0.5%; and
5. A Ge-Cr alloy sputtering target according to any one of paragraphs 1 to 4 above, wherein, in X-ray diffraction, the ratio B/A of the maximum peak intensity A of Ge phase in a 2 θ range of 20° to 30° and of the maximum peak intensity B of GeCr compound phase in a 2 θ range of 30° to 40° is 0.18 or more.
   The present invention also provides:
6. A manufacturing method of a Ge-Cr alloy sputtering target, comprising the steps of evenly dispersing and mixing Cr powder of 75µm or less and Ge powder of 250µm or less having a BET specific surface area of 0.4m²/g or less, and thereafter performing sintering thereto;
7. A manufacturing method of a Ge-Cr alloy sputtering target according to any one of paragraphs 1 to 5 above, comprising the steps of evenly dispersing and mixing Cr powder of 75µm or less and Ge powder of 250µm or less having a BET specific surface area of 0.4m²/g or less, and thereafter performing sintering thereto.
8. A manufacturing method of a Ge-Cr alloy sputtering target according to paragraph 6 or paragraph 7 above, comprising the steps of evenly dispersing and mixing Ge powder having a BET specific surface area of 0.1 to 0.4m²/g, and thereafter performing sintering thereto; and
9. A manufacturing method of a Ge-Cr alloy sputtering target according to any one of paragraphs 6 to 8 above, wherein sintering is performed under the conditions of hot pressing, a sintering temperature of 760 to 900°C and a surface pressure of 75 to 250kg/cm².

### BRIEF DESCRIPTION OF THE DRAWINGS

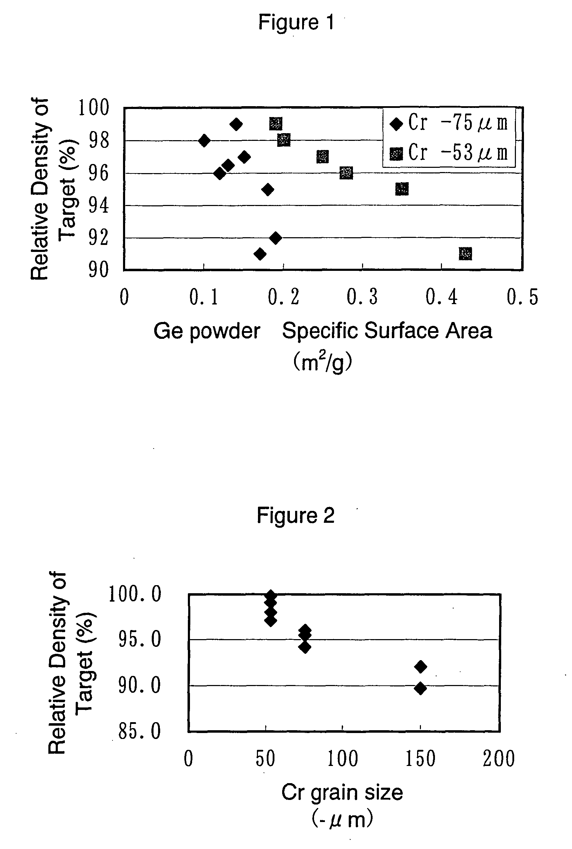

Fig. 1 is a diagram (graph) showing the correlation of the specific surface area of the Ge powder and the relative density (%) of the GeCr target. Fig. 2 is a diagram (graph) showing the correlation of the Cr grain size (minus sieve) and the relative density % of the GeCr target.

### BEST MODE FOR CARRYING OUT THE INVENTION

The sputtering target of the present invention is characterized in that a Ge-Cr alloy sputtering target containing 5 to 50at% of Cr has a relative density of 95% or more, and further a relative density of 97% or more.

This high density Ge-Cr alloy target can be manufactured by evenly dispersing and mixing Cr powder of 75µm or less (hereinafter referred to as the "75µm minus sieve" in this Description) and Ge powder of 250µm or less (hereinafter referred to as the "250µm minus sieve" in this Description) having a BET specific surface area of 0.4m²/g or less, preferably 0.3m²/g or less, and thereafter performing sintering thereto.

This kind of high density Ge-Cr alloy target suppresses the variation of the deposition speed and film composition of the GeCrN thin film formed by reactive sputtering, and significantly reduces the generation of defective products.

The GeCrN thin film formed as described above is extremely effective as an intermediate layer between the recording layer and protective layer of the phase change optical disk.

The relationship of the specific surface area of the Ge powder and the relative density (%) of the GeCr target is shown in Fig. 1. Further, the relationship of the Cr grain size and the relative density (%) of the GeCr target is shown in Fig. 2. These are correlation diagrams of the target when using the minus sieve of the respective powders.

Further, these are each of Ge-20at%Cr and subject to hot pressing under the conditions 800°C × 150kg/cm².

If the relative density of the Ge-Cr alloy sputtering target is less than 95%, variation of the deposition speed and film composition will increase, and the production yield will deteriorate.

Moreover, if Cr powder exceeding the 75µm minus sieve and Ge powder exceeding the 250 µm minus sieve and exceeding the BET specific surface area of 0.4m²/g are used for sintering, a relative density of 95% or more cannot be attained, and, similarly, the variation of the deposition speed and film composition will increase, and the production yield will deteriorate.

Further, it is preferable that the density variation of the Ge-Cr alloy sputtering target is within ±1.5%, and more preferable that the composition variation of the target is within ±0.5%. As a result, the variation of the deposition speed and film composition can be further suppressed.

A GeCr compound phase and a Ge phase exist in the Ge-Cr alloy sputtering target, and it is desirable that, in the X-ray diffraction, the ratio B/A of the maximum peak intensity A of Ge phase in a 2 θ range of 20° to 30° and of the maximum peak intensity B of GeCr compound phase in a 2 θ range of 30° to 40° is 0.18 or more. As a result, the uniformity can be further improved.

Upon manufacturing a Ge-Cr alloy sputtering target, it is desirable to evenly disperse and mix Ge powder having a BET specific surface area of 0.1 to 0.4m²/g, and thereafter performing sintering thereto.

Moreover, upon performing such sintering, it is desirable that sintering is performed by hot pressing under the conditions of a sintering temperature of 760 to 900°C and a surface pressure of 75 to 250kg/cm².

As a result, Ge-Cr alloy sputtering target having a further stable relative density of 95% or more can be manufactured thereby.

Since the increase in density of the sputtering target reduces pores and miniaturizes the crystal grains, and thereby makes the sputtering face of the target even and smooth, a significant effect is yielded in that the formation of particles and nodules during sputtering can be suppressed and the target life can be prolonged.

### Examples and Comparative Examples

The present invention is now described with reference to the Examples and Comparative Examples. These Examples are merely illustrative, and the present invention shall in no way be limited thereby. In other words, the present invention shall only be limited by the scope of claim for a patent, and shall include the various modifications other than the Examples of this invention.

### (Example 1)

Ge powder having a purity of 5N (99.999%) and minus sieve of 100µm and Cr powder having a purity of 3N (99.9%) and a minus sieve of 55µm were prepared, mixed so as to obtain Ge-20at%Cr, and, filled in a carbon die after performing dry blending, and hot-pressed under the conditions of a temperature of 800°C and pressure of 150kg/cm².

This sintered body was subject to finish processing to form a target. The relative density of the target was 99% (5.54g/cm³ at 100% density). The density of samples arbitrarily extracted from three locations of the target was measured with the Archimedes method. The results are shown in Table 1.

Similarly, the composition of samples arbitrarily extracted from three locations of the target was analyzed. The results are shown in Table 2. Further, the results of measuring the X-ray diffraction intensity are shown in Table 3 for the surface of the bulk sample cut from the target, said sample surface being faced against substrate.

Next, reactive sputtering was performed with this target under a nitrogenous argon atmosphere (Ar: N₂ = 25:50sccm) and power of 200W, and a GeCrN film having a thickness of 300Å was formed on a substrate. The measurement results of the variation of film thickness and permeability are shown in Table 4 and Table 5, respectively.

**Table 1**

| Density variation and XRD intensity | | | |
|---|---|---|---|
| Sample | Density | | |
| Example 1 | 99.0% | 98.7% | 99.4% |
| Example 2 | 95.5% | 96.0% | 97.0% |
| Example 3 | 98.8% | 99.5% | 99.2% |
| Comparative Example 1 | 88.0% | 90.2% | 92.0% |
| Comparative Example 2 | 90.3% | 95.2% | 92.0% |

**Table2**

| Variation in Composition | | | |
|---|---|---|---|
| Sample | Composition | | |
| Example 1 | 19.6% | 20.2% | 19.8% |
| Example 2 | 19.7% | 20.4% | 19.9% |
| Example 3 | 50.2% | 49.6% | 50.2% |
| Comparative Example 1 | 19.9% | 18.9% | 20.6% |
| Comparative Example 2 | 19.7% | 21.5% | 19.2% |

**Table3**

| XRD intensity ratio | |
|---|---|
| Sample | B/A |
| Example 1 | 0.24 |
| Example 2 | 0.31 |
| Comparative Example 1 | 0.10 |
| Comparative Example 2 | 0.16 |

**Table4**

| Sample | Film Thickness (nm) | | | | | | | | | Average | σ |
|---|---|---|---|---|---|---|---|---|---|---|---|
| | 1 | 2 | 3 | 4 | 5 | 6 | 7 | 8 | 9 | | |
| Example 1 | 290 | 325 | 295 | 315 | 330 | 310 | 285 | 290 | 290 | 303.3 | 17.0 |
| Example 2 | 290 | 315 | 300 | 300 | 325 | 310 | 280 | 305 | 285 | 301.1 | 14.5 |
| Example 3 | 285 | 320 | 280 | 315 | 335 | 320 | 275 | 310 | 290 | 303.3 | 21.2 |
| Comparative Example 1 | 300 | 330 | 280 | 360 | 355 | 320 | 280 | 315 | 260 | 311.1 | 34.3 |
| Comparative Example 2 | 315 | 295 | 260 | 350 | 345 | 275 | 325 | 255 | 265 | 298.3 | 36.8 |

**Table5**

| Sample | Permeability (%) 630nm | | | | Average | σ |
|---|---|---|---|---|---|---|
| | A | B | C | D | | |
| Example 1 | 78.5 | 78.4 | 77.6 | 77.6 | 78.0 | 0.5 |
| Example 2 | 79.0 | 78.8 | 78.2 | 77.9 | 78.5 | 0,5 |
| Example 3 | 50.2 | 49.5 | 51.3 | 50.5 | 50.4 | 0.7 |
| Comparative Example 1 | 79.2 | 73.2 | 74.3 | 84.1 | 77.7 | 5.0 |
| Comparative Example 2 | 77.2 | 84.5 | 76.5 | 84.1 | 80.6 | 4.3 |

### (Example 2)

Ge powder having a purity of 5N (99.999%) and minus sieve of 200µm and Cr powder having a purity of 3N (99.9%) and a minus sieve of 55µm were prepared, mixed so as to obtain Ge-20at%Cr, filled in a carbon die after performing dry blending, and hot-pressed under the conditions of a temperature of 800°C and pressure of 100kg/cm².

This sintered body was subject to finish processing to form a target. The relative density of the target was 96% (5.54g/cm³ at 100% density). The density of samples arbitrarily extracted from three locations of the target was measured with the Archimedes method. The results are shown in Table 1.

Similarly, the composition of samples arbitrarily extracted from three locations of the target was analyzed. The results are shown in Table 2. Further, the results of measuring the X-ray diffraction intensity are shown in Table 3 for the surface of the bulk sample cut from the target, said sample surface being faced against substrate.

Next, reactive sputtering was performed with this target under a nitrogenous argon atmosphere (Ar: N₂ = 25:50sccm) and power of 200W, and a GeCrN film having a thickness of 300Å was formed on a substrate. The measurement results of the variation of film thickness and permeability are shown in Table 4 and Table 5, respectively.

### (Example 3)

Ge powder having a purity of 5N (99.999%) and minus sieve of 75µm and Cr powder having a purity of 3N (99.9%) and a minus sieve of 25µm were prepared, mixed so as to obtain Ge-50at%Cr, filled in a carbon die after performing dry blending, and hot-pressed under the conditions of a temperature of 800°C and pressure of 150kg/cm².

This sintered body was subject to finish processing to form a target. The relative density of the target was 97% (5.97g/cm³ at 100% density). The density of samples arbitrarily extracted from three locations of the target was measured with the Archimedes method. The results are shown in Table 1.

Similarly, the composition of samples arbitrarily extracted from three locations of the target was analyzed. The results are shown in Table 2. Further, the results of measuring the X-ray diffraction intensity are shown in Table 3 for the surface of the bulk sample cut from the target, said sample surface being faced against substrate.

Next, reactive sputtering was performed with this target under a nitrogenous argon atmosphere (Ar: N₂ = 25:50sccm) and power of 200W, and a GeCrN film having a thickness of 300Å was formed on a substrate. The measurement results of the variation of film thickness and permeability are shown in Table 4 and Table 5, respectively.

### (Comparative Example 1)

Ge powder having a purity of 5N (99.999%) and minus sieve of 300 µm and Cr powder having a purity of 3N (99.9%) and a minus sieve of 150µm were prepared, mixed so as to obtain Ge-20at%Cr, filled in a carbon die after performing dry blending, and hot-pressed under the conditions of a temperature of 800°C and pressure of 50kg/cm².

This sintered body was subject to finish processing to form a target. The relative density of the target was 90% (5.54g/cm³ at 100% density). The density of samples arbitrarily extracted from three locations of the target was measured with the Archimedes method. The results are shown in Table 1.

Similarly, the composition of samples arbitrarily extracted from three locations of the target was analyzed. The results are shown in Table 2. Further, the results of measuring the X-ray diffraction intensity are shown in Table 3 for the surface of the bulk sample cut from the target, said sample surface being faced against substrate.

Next, reactive sputtering was performed with this target under a nitrogenous argon atmosphere (Ar: N₂ = 25:50sccm) and power of 200W, and a GeCrN film having a thickness of 300Å was formed on a substrate. The measurement results of the variation of film thickness and permeability are shown in Table 4 and Table 5, respectively.

### (Comparative Example 2)

Ge powder having a purity of 5N (99.999%) and minus sieve of 350µm and Cr powder having a purity of 3N (99.9%) and a minus sieve of 75µm were prepared, mixed so as to obtain Ge-20at%Cr, filled in a carbon die after performing dry blending, and hot pressed under the conditions of a temperature of 750°C and pressure of 100kg/cm².

This sintered body was subject to finish processing to form a target. The relative density of the target was 93% (5.54g/cm³ at 100% density). The density of samples arbitrarily extracted from three locations of the target was measured with the Archimedes method. The results are shown in Table 1.

Similarly, the composition of samples arbitrarily extracted from three locations of the target was analyzed. The results are shown in Table 2. Further, the results of measuring the X-ray diffraction intensity are shown in Table 3 for the surface of the bulk sample cut from the target, said sample surface being faced against substrate.

Next, reactive sputtering was performed with this target under a nitrogenous argon atmosphere (Ar: N₂ = 25:50sccm) and power of 200W, and a GeCrN film having a thickness of 300Å was formed on a substrate. The measurement results of the variation of film thickness and permeability are shown in Table 4 and Table 5, respectively.

As is evident from Examples 1 to 3 and Comparative Examples 1 and 2 shown in Table 1, the relative density of Examples 1 to 3 was each 95% or more, and, with respect to Example 1 and Example 3, a relative density of 97% or more was attained. And in each of these cases, the density variation in the target was within ±1.5%.

Contrarily, the relative density of Comparative Example 1 and Comparative Example 2 was less than 95%, and the density variation in the target exceeded ±1.5%.

As shown in Table 2, the composition variation in the target of Examples 1 to 3 was each within ±0.5%.

Contrarily, the composition variation in the target of Comparative Example 1 and Comparative Example 2 exceeded ±0.5%.

Table 3 shows, for Examples 1 to 2 and Comparative Examples 1 and 2, the ratio B/A of maximum peak intensity A of Ge phase in a 2 θ range of 20° to 30° and the maximum peak intensity B of GeCr compound phase in a 2 θ range of 30° to 40°. It is evident that Examples 1 to 2 satisfy the condition of the present invention, i.e. 0.18 or more. However, with Comparative Examples 1 and 2, B/A was less than 0.18.

The evaluation results of the variation of the film thickness and transmittance for the target having the foregoing characteristics are shown in Table 4. It is evident that the variation of the film thickness and transmittance in Examples 1 to 3 is significantly small. Contrarily, the variation of the film thickness and transmittance in Comparative Examples 1 and 2 is significantly large, and is not suitable for a target.

Moreover, the high density sputtering target of the present invention is able to suppress the formation of particles and nodules which take place during sputtering, and has an effect of improving the film thickness uniformity. Contrarily, since the density was low in the targets of Comparative Examples 1 and 2, abnormal discharge occurred during sputtering, and consequently there was a problem of increase in the formation of particles (dust) and nodules.

Accordingly, it is evident that the sputtering target of the present invention is extremely effective in forming a GeCrN layer deposited by reactive sputtering as the intermediate layer between the recording layer and protective layer of the phase change optical disk.

### Effect of the Invention

When forming a GeCrN thin film by reactive sputtering employing the high density Ge-Cr alloy sputtering target of the present invention, the variation of the deposition speed and the accompanying composition deviation can be effectively suppressed, and a superior effect is yielded in that stable sputtering characteristics can be obtained. As a result, the incidence rate of defective products can be significantly reduced. Further, upon sputtering, the generation of particles and nodules can be reduced, and the film thickness uniformity can also be improved.

## Claims

1. A Ge-Cr alloy sputtering target containing 5 to 50at% of Cr and having a relative density of 95% or more;

2. A Ge-Cr alloy sputtering target according to paragraph 1 above, wherein the relative density is 97% or more;

3. A Ge-Cr alloy sputtering target according to paragraph 1 or paragraph 2 above, wherein the density variation in the target is within ±1.5%;

4. A Ge-Cr alloy sputtering target according to any one of paragraphs 1 to 3 above, wherein the composition variation in the target is within ±0.5%; and

5. A Ge-Cr alloy sputtering target according to any one of paragraphs 1 to 4 above, wherein, in X-ray diffraction, the ratio B/A of the maximum peak intensity A of Ge phase in a 2 θ range of 20° to 30° and of the maximum peak intensity B of GeCr compound phase in a 2 θ range of 30° to 40° is 0.18 or more.
The present invention also provides:

6. A manufacturing method of a Ge-Cr alloy sputtering target, comprising the steps of evenly dispersing and mixing Cr powder of 75µm or less and Ge powder of 250µm or less having a BET specific surface area of 0.4m²/g or less, and thereafter performing sintering thereto;

7. A manufacturing method of a Ge-Cr alloy sputtering target according to any one of paragraphs 1 to 5 above, comprising the steps of evenly dispersing and mixing Cr powder of 75µm or less and Ge powder of 250µm or less having a BET specific surface area of 0.4m²/g or less, and thereafter performing sintering thereto.

8. A manufacturing method of a Ge-Cr alloy sputtering target according to paragraph 6 or paragraph 7 above, comprising the steps of evenly dispersing and mixing Ge powder having a BET specific surface area of 0.1 to 0.4m²/g, and thereafter performing sintering thereto; and

9. A manufacturing method of a Ge-Cr alloy sputtering target according to any one of paragraphs 6 to 8 above, wherein sintering is performed under the conditions of hot pressing, a sintering temperature of 760 to 900°C and a surface pressure of 75 to 250kg/cm².

## Amended claims

### Amended claims under Art. 19.1 PCT

1. (Amended) A Ge-Cr alloy sputtering target containing 5 to 50at% of Cr **characterizing in that** said target has a relative density of 97% or more, that the density variation of said target is within ±1.5%, and that, in X-ray diffraction, the ratio B/A of the maximum peak intensity A of Ge phase in a 2 θ range of 20° to 30° and of the maximum peak intensity B of GeCr compound phase in a 2θ range of 30° to 40° is 0.18 or more.

2. (Delete)

3. (Delete)

4. (Amended) Ge-Cr alloy sputtering target according to claim 1, wherein the composition variation in the target is within ±0.5%.

5. (Delete)

6. A manufacturing method of a Ge-Cr alloy sputtering target, comprising the steps of evenly dispersing and mixing Cr powder of 75µm or less, and Ge powder of 250µm or less and having a BET specific surface area of 0.4m²/g or less, and thereafter performing sintering thereto.

7. (Amended) A manufacturing method of a Ge-Cr alloy sputtering target according to claim 1 or claim 4, comprising the steps of evenly dispersing and mixing Cr powder of 75 µm or less, and Ge powder of 250 µm or less and having a BET specific surface area of 0.4m²/g or less, and thereafter performing sintering thereto.

8. A manufacturing method of a Ge-Cr alloy sputtering target according to claim 6 or claim 7, comprising the steps of evenly dispersing and mixing Ge powder of 250µm or less having a BET specific surface area of 0.1 to 0.4m²/g, and thereafter performing sintering thereto.

9. A manufacturing method of a Ge-Cr alloy sputtering target according to any one of claims 6 to 8, wherein sintering is performed under the conditions of hot pressing, a sintering temperature of 760 to 900°C, and a bearing of 75 to 250kg/cm².
